Europäisches Patentamt

European Patent Office

Office européen des brevets

(19)

(11) EP 0 704 981 A1

(12) **DEMANDE DE BREVET EUROPEEN**

(43) Date de publication:
03.04.1996 Bulletin 1996/14

(51) Int Cl.6: **H03M 13/12, H04L 7/04**

(21) Numéro de dépôt: 95402140.8

(22) Date de dépôt: 22.09.1995

(84) Etats contractants désignés:
DE ES GB IT NL SE

(30) Priorité: 27.09.1994 FR 9411516

(71) Demandeur: ALCATEL TELSPACE
F-92734 Nanterre Cédex (FR)

(72) Inventeurs:
• Fang, Juing
F-95000 Cergy Pontoise (FR)
• Kimiavi, Mani
F-75019 Paris (FR)

(74) Mandataire: Scheer, Luc et al
SOSPI
14-16, rue de la Baume
F-75008 Paris (FR)

(54) **Dispositif de synchronisation de branches d'un décodeur de viterbi compris dans un récepteur de données numériques codées en treillis multidimensionnel**

(57) L'invention concerne un dispositif de synchronisation de branches pour récepteur de données numériques codées en treillis multidimensionnel à l'aide d'un codeur convolutif. Le dispositif comprend un décodeur de Viterbi (15) recevant deux trains de symboles (I, Q) et fournissant des séquences codées ($Z_0$, $Z_1$, $Z_2$), ainsi que des moyens (11,12) de décalage temporel des trains de symbole (I, Q) appliqués au décodeur de Viterbi (15). Les moyens (11, 12) de décalage temporel sont pilotés par des moyens (18, 19, 20) de décision de synchronisation de branches générant un signal (SCT) de commande de décalage temporel des trains de symboles (I, Q).

Selon l'invention, les moyens (18,19, 20) de décision de synchronisation de branches comportent un circuit de calcul (20) recevant les séquences codées ($Z_0$, $Z_1$, $Z_2$), le circuit de calcul (20) fournissant un signal de sortie (SCD) constant lorsque les séquences codées ($Z_0$, $Z_1$, $Z_2$) correspondent à des séquences qui seraient issues du codeur convolutif et fournissant un signal de sortie (SCD) présentant des changements de niveau lorsque les séquences codées ($Z_0$, $Z_1$, $Z_2$) ne correspondent pas à des séquences qui seraient issues de ce codeur convolutif, le signal de sortie (SCD) étant appliqué aux moyens (18,19, 20) de décision de synchronisation de branches.

FIG.5

## Description

Le domaine de l'invention est celui des récepteurs de données numériques et concerne plus précisément un récepteur de données numériques codées en treillis multidimensionnel (TCM, Trellis Coded Modulation), ce récepteur comprenant un dispositif de synchronisation de branches d'un décodeur de Viterbi.

Les modems à codage en treillis multidimensionnel utilisent des symboles constitués d'une pluralité de symboles QAM (Quadrature Amplitude Modulation) ou M-PSK (Multiple Phase Shift Keying) à deux dimensions. A l'émission, une partie des données numériques à transmettre subissent un codage convolutif, linéaire ou non, et les données ainsi codées, ainsi que celles non codées, sont appliquées à une unité de mapping fournissant les données à transmettre. Le récepteur comporte, après démodulation, un circuit de calcul de métrique de branches recevant deux trains de symboles, généralement appelés I et Q, ce circuit de calcul de métrique de branches étant suivi par un décodeur de Viterbi fournissant des séquences codées. Les séquences codées sont ensuite appliquées à une unité de demapping qui restitue les données originelles.

Une des caractéristiques du codage en treillis multidimensionnel est qu'il est nécessaire de synchroniser l'horloge du décodeur de Viterbi du récepteur pour que ce décodeur travaille sur des blocs de codes entiers, c'est à dire qu'il connaisse le symbole constituant le premier d'une branche. S'il prend le deuxième ou le troisième symbole pour débuter le décodage d'une branche, la démodulation échoue et le résultat de sortie est erroné. Cette synchronisation s'appelle la synchronisation de branches et est notamment évoquée dans l'article "A technique for multidimensional symbol and multiplexing frame synchronization in multidimensional trellis coded modems using non-standard baud" de M. D. Rauchwerk, Proc. ICC'88, IEEE, Philadelphia, pp.80-84, Juin 1988. Afin de récupérer aussi rapidement que possible la synchronisation de branches à l'établissement d'une liaison, cet article décrit une méthode classique qui consiste à surveiller la convergence des métriques de chemins dans le décodeur de Viterbi.

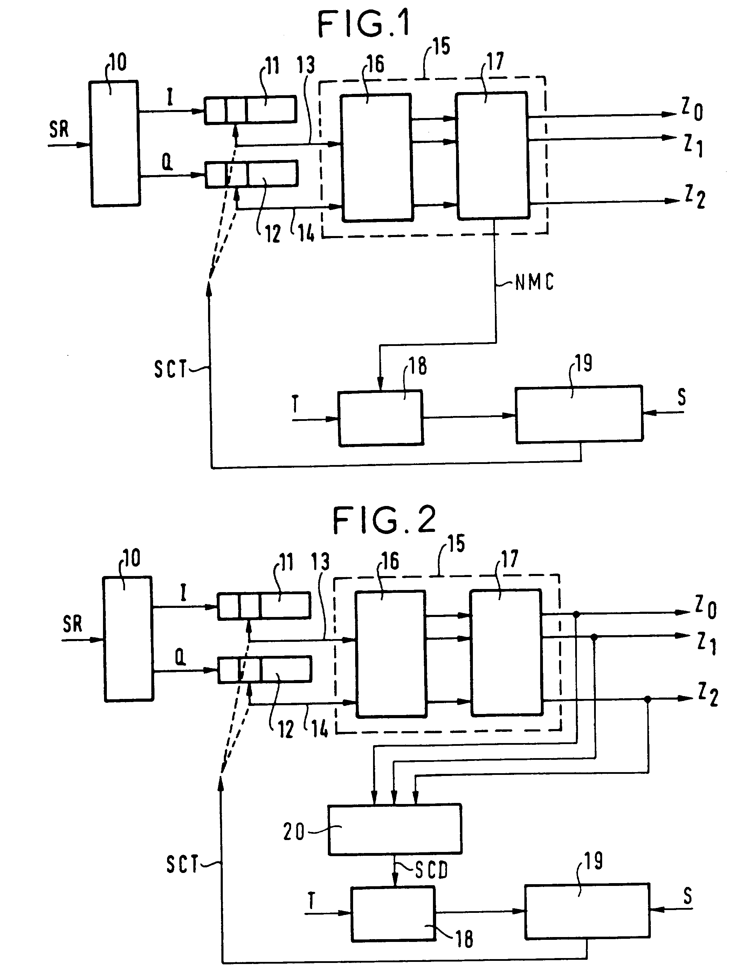

La figure 1 est un schéma synoptique d'un dispositif de synchronisation de branches connu, fonctionnant selon la méthode de détection des convergences des métriques de chemin.

Ce dispositif est destiné à être implanté dans un récepteur de données numériques codées en treillis multidimensionnels. Le signal SR reçu par le récepteur est appliqué à un démodulateur 10 fournissant deux trains numériques, notés I et Q. Ces trains de symboles sont appliqués à des moyens de décalage temporel 11 et 12 constitués par des registres à décalages, dont le nombre d'emplacements mémoire correspond au nombre d'hypothèses de décalage temporel possibles. A titre d'exemple, pour une modulation TCM 3x8PSK, 3 emplacements sont prévus dans chaque registre à décalage. Les symboles sont lus dans ces registres sur des liaisons 13 et 14 constituant les deux entrées d'un décodeur de Viterbi 15. Le décodeur de Viterbi 15 comporte un calculateur de métrique de branches 16 suivi par un circuit de décodage 17 fournissant sur des sorties des séquences codées $Z_0$, $Z_1$ et $Z_2$ (cas d'un codeur à 6 dimensions). Ces séquences codées sont ensuite appliquées à une unité de demapping réalisant une opération inverse de celle opérée au niveau de l'émetteur par l'unité de mapping.

Le décodeur de Viterbi 15 comporte une sortie fournissant un signal NMC indicateur de la normalisation des métriques de chemin. Ce signal est généré dans le circuit de décodage 17 à l'aide d'un algorithme de détection des divergences des métriques fournies par le circuit 16. Le signal NMC est appliqué à un compteur 18 qui compte le nombre de changements d'états du signal NMC pendant une durée prédéterminée notée T. Le résultat de ce comptage est fourni à un comparateur 19 recevant une valeur de seuil prédéterminé S. Si le résultat du comptage est supérieur à la valeur de seuil S, un signal de commande de décalage temporel SCT est généré par le comparateur 19, ce signal SCT étant appliqué aux moyens de décalage temporel 11, 12 des trains de symbole appliqués au décodeur de Viterbi 15. Les trains de symbole appliqués au décodeur de Viterbi 15 sont alors décalés d'un temps symbole. Ainsi, l'algorithme de détection des divergences des métriques, le compteur 18 et le comparateur 19 constituent des moyens permettant de détecter la synchronisation de branches.

L'inconvénient de ce dispositif de synchronisation est que la synchronisation de branches est longue à acquérir puisqu'elle nécessite quelques centaines de temps symbole. A titre d'exemple, pour un codage convolutif de type QPSK subissant un poinçonnage de rendement 3/4, 800 symboles sont nécessaires pour décider si la séquence présentée à l'entrée du décodeur de Viterbi 15 doit ou non être décalée.

De plus, lorsqu'on travaille avec un schéma multidimensionnel, le temps de convergence est multiplié par le nombre de symboles de modulation par branche du treillis. A titre d'exemple, pour une modulation TCM de type 3x8 PSK, chaque branche du treillis utilisé dans le décodage de Viterbi représente 3 symboles 8PSK en série. Le temps de convergence est alors multiplié par 3.

Enfin, les symboles pris en compte sont ceux appliqués au décodeur de Viterbi et ils peuvent être entachés d'erreurs dues à la transmission. On peut ainsi détecter une divergence des métriques due non pas à une non-synchronisation de branches mais à des perturbations affectant le signal reçu (évanouissement sélectif générant des distorsions inter-symboles, ...). La synchronisation sera alors corrigée alors qu'elle ne devrait pas l'être.

La présente invention a notamment pour objectif de remédier à ces inconvénients.

Plus précisément, un des objectifs de l'invention est de fournir un dispositif de synchronisation de branches rapide et fiable pour récepteur de données numériques codées en treillis multidimensionnels.

Cet objectif, ainsi que d'autres qui apparaîtront par la suite, est atteint grâce à un dispositif de synchronisation de branches pour récepteur de données numériques codées en treillis multidimensionnel à l'aide d'un codeur convolutif, le dispositif comprenant un décodeur de Viterbi recevant deux trains de symboles issus d'un signal reçu et fournissant des séquences codées, ainsi que des moyens de décalage temporel des trains de symbole, les moyens de décalage temporel étant pilotés par des moyens de décision de synchronisation de branches engendrant un signal de commande de décalage temporel. Selon l'invention, les moyens de décision de synchronisation de branches coopèrent avec un circuit de calcul recevant les séquences codées et fournissant aux moyens de décision de synchronisation un signal de sortie d'un premier type lorsque les séquences codées correspondent à des séquences qui seraient directement issues du codeur convolutif, ou fournissant un signal de sortie d'un deuxième type lorsque les séquences codées ne correspondent pas à des séquences qui seraient issues de ce codeur convolutif, le signal de sortie étant appliqué aux moyens de décision de synchronisation de branches, en vue de déterminer le signal de commande de décalage.

Ainsi, la synchronisation de branches est obtenue bien plus rapidement que dans l'état de la technique. Le gain de temps est de l'ordre de 5.

Les signaux de sortie du premier et du deuxième type peuvent être constitués par des signaux numériques, le signal de sortie du premier type étant par exemple un niveau logique constant (0 ou 1) en l'absence de perturbations (absence de bruit et synchronisation de branches acquise).

Dans un premier mode de réalisation, les moyens de décision de synchronisation de branches comprennent un dispositif à seuil générant un signal de commande de décalage temporel lorsque le nombre de changements de niveaux du signal de sortie, observé pendant une durée donnée, atteint une valeur de seuil. La durée donnée et la valeur de seuil peuvent être prédéterminées ou non.

Lorsque la durée donnée et la valeur de seuil ne sont pas prédéterminées, les moyens de décision de synchronisation de branches comprennent avantageusement également un circuit de décision de fausse alarme auquel est appliqué le signal de commande de décalage temporel, ce circuit de détection de fausse alarme corrigeant la valeur de la durée d'observation et/ou de la valeur de seuil lorsque toutes les hypothèses de décalage temporel ont été testées sans obtenir la synchronisation de branches. On réalise ainsi un dispositif de synchronisation de branches auto-adaptatif aux conditions de transmission.

Dans un deuxième mode de réalisation, les moyens de décision de synchronisation de branches comprennent un compteur des changements de niveau du signal de sortie pendant une durée prédéterminée, le compteur fournissant, pour chaque hypothèse de décalage temporel, le nombre de changements de niveaux observé à un dispositif de commande qui décale les trains de symbole pour que les trains de symbole appliqués au décodeur de Viterbi soient ceux pour lesquels le nombre de changements de niveaux observé est le plus faible. Dans ce deuxième mode de réalisation, toutes les hypothèses de décalage sont donc testées successivement et celle pour laquelle la synchronisation de branches est obtenue est conservée.

L'invention s'applique non seulement aux codeurs convolutifs linéaires, dans quel cas le circuit de calcul peut être constitué par un calculateur de syndrome, mais également aux codeurs convolutifs non linéaires, le circuit de calcul étant alors un agencement de logique combinatoire dérivé de la construction du codeur convolutif non linéaire.

L'invention concerne également un récepteur de données numériques codées en treillis multidimensionnel comprenant un tel dispositif de synchronisation de branches.

D'autres caractéristiques et avantages de l'invention apparaîtront à la lecture de la description suivante de plusieurs modes de réalisation préférentiels, donnés à titre illustratif et non limitatif, et des dessins annexés dans lesquels :

- la figure 1 est un schéma synoptique d'un dispositif de synchronisation de branches connu, fonctionnant selon la méthode de détection des convergences des métriques de chemin ;
- la figure 2 est un schéma synoptique d'un premier mode de réalisation du dispositif de synchronisation de branches de l'invention ;
- les figures 3 et 4 représentent respectivement un codeur convolutif non linéaire à 8 états de phase et le dispositif de calcul de la figure 1 correspondant ;
- les figures 5 et 6 sont des schémas synoptiques de deux autres modes de réalisation du dispositif de synchronisation de branches de l'invention, assurant une auto-adaptativité aux conditions de transmission.

La figure 1 a été décrite précédemment en référence à l'état de la technique.

La figure 2 est un schéma synoptique d'un premier mode de réalisation du dispositif de synchronisation de branches de l'invention. Les éléments identiques à ceux de la figure 1 portent les mêmes références.

Le dispositif de synchronisation de branches de l'invention diffère de celui présenté en figure 1 en ce que les séquences codées $Z_0$, $Z_1$ et $Z_2$, issues du décodeur de Viterbi 15, sont appliquées à un circuit de calcul 20 dont la fonction est de fournir un signal de sortie, noté SCD, d'un premier type lorsque la synchronisation de branches est obtenue ou d'un deuxième type lorsque la synchronisation de branches n'est pas obtenue. A titre d'exemple, le signal SCD peut être constitué par un niveau logique constant (par exemple 0) lorsque la synchronisation de branches est obtenue et constitué par des changements de niveau logique (alternance entre des niveaux 0 et 1) lorsque la synchronisation de branches est perdue. D'autres alternatives sont possibles.

Le signal SCD est appliqué à un dispositif à seuil constitué par un compteur 18 suivi par un comparateur 19 recevant une valeur de seuil S prédéterminée. Le compteur 18 fournit au comparateur 19 le nombre de changements d'état du signal SCD, observé pendant une durée T. Si ce nombre de changements de niveaux atteint la valeur de seuil S, le comparateur 19 provoque le pointage d'un emplacement mémoire des registres 11 et 12 adjacent à l'emplacement courant, ce qui revient à décaler temporellement d'un temps symbole les trains de symbole I et Q appliqués au décodeur de Viterbi 15.

Si le nombre de changements de niveaux comptés pendant la durée T n'atteint pas la valeur de seuil S, le compteur 18 est remis à zéro et repart pour un nouveau cycle de comptage. Ceci revient à considérer que la synchronisation de branches est acquise.

On détecte donc un certain nombre de changements de niveaux à la sortie du circuit de calcul 20 pour décider un décalage des signaux appliqués au décodeur de Viterbi 15. Ainsi, si chaque branche représente M symboles, il faut au maximum M-1 décalages pour retrouver le début de branche.

Différents modes de réalisation sont possibles. On peut par exemple configurer le circuit de calcul 20 pour qu'il fournisse un niveau logique 0 lorsque la synchronisation de branches est acquise, alors que son signal de sortie devient une succession aléatoire de 1 et de 0 lorsque cette synchronisation ne l'est pas. Le compteur 18 peut alors simplement compter le nombre de 1 dans le signal SCD.

La structure du circuit de calcul 20 dépend de celle du codeur convolutif utilisé à l'émission. Sa conception est basée sur le principe qu'aussi longtemps que le décodeur de Viterbi 15 fournit des séquences attendues, sa synchronisation de branches est correcte. De manière générale, sa structure est donc conçue pour qu'il délivre un niveau logique constant s'il était placé en aval du codeur utilisé à l'émission. On peut donc considérer qu'il joue le rôle d'un annulateur du codeur d'émission. Un changement de niveau à sa sortie signifie donc, lorsqu'il est utilisé en réception, soit une erreur de transmission due à la propagation hertzienne, qui ne provoque pas de décalage des trains de symboles lorsque les valeurs du seuil S et du délai T sont correctement choisies, soit que la synchronisation de branches n'est pas acquise.

Si le codeur à l'émission est un codeur convolutif linéaire, le circuit 20 peut être un simple calculateur de syndrome. On se référera notamment à l'article de G.D. FORNEY Jr. Intitulé "Convolutional codes I : Algebraic structure", IEEE Trans. on Information Theory, vol.IT-16, pp.720-738, nov.1970 pour la réalisation de calculateurs de syndromes. S'il s'agit par contre d'un codeur non linéaire, la notion de syndrome n'existe pas. On peut cependant alors également réaliser un circuit de calcul fournissant un niveau logique constant aussi longtemps que, en faisant abstraction des erreurs de transmission, les séquences codées correspondent à des séquences attendues.

De manière générale, la réalisation de ce circuit peut être simplement constitué par un agencement de logique combinatoire dérivé de la construction du codeur convolutif utilisé à l'émission.

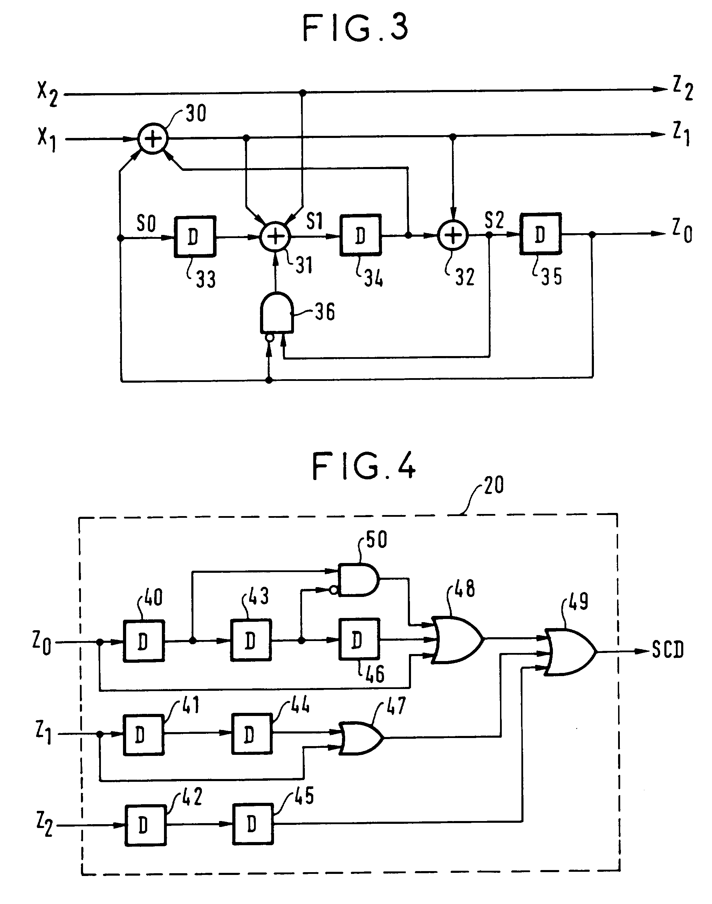

A titre d'exemple, les figures 3 et 4 représentent respectivement un codeur convolutif non linéaire à 8 états de phase et le circuit de calcul 20 de la figure 2 correspondant.

Le codeur convolutif non linéaire de la figure 3 correspond à celui de la recommandation V32 bis du CCITT pour la transmission de données modulées MAQ pour la voie téléphonique. Ce codeur reçoit en entrée deux données $X_1$ et $X_2$ et fournit trois données $Z_2$, $Z_1$ et $Z_0$ en sortie (rendement 2/3). Six autres données non représentées ($X_3$ à $X_8$) sont appliquées à une unité de mapping recevant également les données $Z_0$ à $Z_2$. Le codeur comporte trois sommateurs 30 à 32, constitués par des portes Ou, trois bascules 33 à 35 apportant chacune un retard d'un temps symbole D, et une porte Et 36 à une entrée inverseuse. Les équations de sortie de ce codeur convolutif sont les suivantes :

$$Z_0(t) = S_2(t-1)$$

$$Z_1(t) = X_1(t) \oplus S_2(t-1) \oplus S_1(t-1)$$

$$Z_2(t) = X_2(t)$$

avec $\oplus$ l'opérateur Ou-Exclusif.

Les équations de transition d'état de ce codeur sont :

$$S_0(t) = S_2(t-1)$$

$$S_1(t) = Z_1(t) \oplus X_2(t) \oplus S_0(t-1) \oplus [\overline{S_2(t-1)} \cdot (Z_1(t) \oplus S_1(t-1))]$$

$$S_2(t) = Z_1(t) \oplus S_1(t-1)$$

avec $S_0$, $S_1$ et $S_2$ les entrées respectives des bascules 21, 22 et 23.

En combinant ces équations, on obtient :

$$Z_0(t) = Z_1(t-1) \oplus S_1(t-2)$$
$$= Z_1(t-1) \oplus Z_1(t-2) \oplus X_2(t-2) \oplus S_0(t-3) \oplus [\overline{Z_0(t-2)} . (Z_1(t-2) \oplus S_1(t-3))]$$
$$= Z_1(t-1) \oplus Z_1(t-2) \oplus Z_2(t-2) \oplus Z_0(t-3) \oplus [\overline{Z_0(t-2)} . Z_0(t-1)]$$

L'objectif du circuit de calcul 20 est ici d'annuler sa sortie (SCD = 0) pour toute séquence générée par le codeur de la figure 3. Il faut donc que l'égalité suivante soit respectée :

$$Z_0(t) \oplus Z_1(t-1) \oplus Z_1(t-2) \oplus Z_2(t-2) \oplus Z_0(t-3) \oplus [\overline{Z_0(t-2)} . Z_0(t-1)] = 0$$

Cette égalité s'écrit dans le domaine D (opérateur de délai) de la manière suivante :

$$[(1 \oplus D^3). Z_0(D)] \oplus [(D \oplus D^2).Z_1(D)] \oplus [D^2 Z_2(D)] \oplus [\overline{D^2 Z0(D)} . DZ_0(D)] = 0$$

Le schéma d'un circuit réalisant cette opération est donné à la figure 4. Il comporte sept bascules 40 à 46, trois portes Ou 47 à 49 et une porte Et 50 à une entrée inverseuse. Le signal de sortie de la porte Ou 49 constitue le signal SCD appliqué au compteur 18 de la figure 2. Il est donc possible de réaliser un circuit "annulateur de codeur" pour un codeur convolutif non linéaire.

La valeur du seuil S et de la période de comptage T conditionnent la performance du dispositif de l'invention, exprimée en terme de probabilité de fausse alarme $p_{fa}$ et de non détection $p_{nd}$. Ces deux probabilités sont à minimiser. A titre d'exemple, en considérant que lorsque le signal SCD vaut 0 la synchronisation de branches est acquise, on peut déterminer deux lois de probabilités conditionnelles des nombres de niveaux logiques 1 qui fournissent deux formules analytiques permettant de calculer les probabilités suivantes :

$$p(\#1 = i/SA) \text{ et } p(\#1 = j/NS)$$

où #1 signifie "nombre de 1", i et j sont des variables, SA signifie "synchronisation acquise" et NS signifie "non synchronisation".

Ces deux densités de probabilité sont estimées par des simulations ou des mesures. On calcule ensuite les probabilités suivantes :

$$p_{nd} = \sum_{j=0}^{j=S-1} p(\#1 = j/NS) \text{ et } p_{fa} = \sum_{i=S}^{i=T-1} p(\#1 = i/SA)$$

Pour permettre une acquisition de synchronisation de branches rapide, il faut que la durée T soit la plus petite possible, tout en sachant que plus T est faible, plus la probabilité de fausse alarme $p_{fa}$ est grande. De même, la valeur du seuil S sera choisie la plus petite possible afin d'avoir une probabilité de non détection $p_{nd}$ faible, tout en sachant que plus S est faible, plus la probabilité de fausse alarme $p_{fa}$ est grande. En pratique, il est conseillé de fixer au préalable les probabilités $P_{nd}$ et $p_{fa}$ souhaitées, d'obtenir par simulations ou mesures les valeurs de p(#1 = j/NS) et de p(#1 = i/SA), puis de calculer le seuil S et la durée T en inversant les équations précédentes. La durée T et le seuil S sont ici prédéterminés.

Les moyens de décalage temporel 11 et 12 peuvent être remplacés par un système de sélection d'horloge permettant de synchroniser l'horloge du décodeur de Viterbi sur les trains entrants. On peut par exemple prévoir trois horloges (dans le cas du 3x8PSK) décalées chacune d'un temps symbole par rapport à l'autre et appliquées à un multiplexeur dont la sortie pilote le décodeur de Viterbi. L'horloge sélectionnée est celle pour laquelle la synchronisation de branche est acquise.

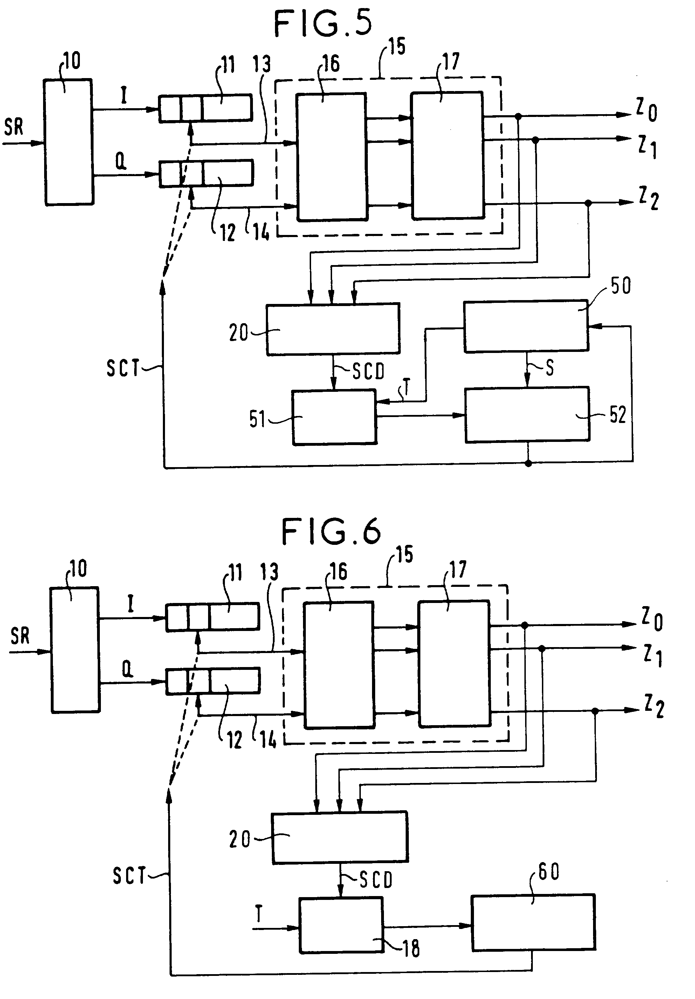

Le dispositif de synchronisation de branches décrit jusqu'ici suppose que l'on connaisse au préalable les conditions de propagation pour pouvoir définir les probabilités $P_{nd}$ et $p_{fa}$ et définir en conséquence les valeurs de T et S. Ces conditions de propagation sont connues suffisamment précisément lorsque le dispositif de l'invention est par exemple utilisé pour une transmission de données par satellite géostationnaire. En revanche, lorsque le milieu de transmission n'est pas stationnaire (présence d'obstacles potentiels, milieu bruité,...), notamment pour les transmissions par faisceaux hertziens, il est intéressant d'assurer une auto-adaptativité du dispositif aux conditions de transmission. A cet effet, le dispositif de synchronisation de branches de l'invention peut être conforme à l'un de ceux représentés aux figures 5 et 6.

Les figures 5 et 6 sont des schémas synoptiques de deux autres modes de réalisation du dispositif de synchronisation de branches de l'invention, assurant une auto-adaptativité aux conditions de transmission.

Le mode de réalisation de la figure 5 diffère de celui de la figure 2 en ce que les moyens de décision de synchronisation de branches comprennent également un circuit 50 de détection de fausse alarme auquel est appliqué le signal de commande de décalage temporel SCT. Ce circuit 50 a pour fonction de corriger la valeur de la durée de comptage T et/ou de la valeur de seuil S lorsque toutes les hypothèses de décalage temporel ont été testées sans obtenir de synchronisation de branches. A titre d'exemple, dans le cas du 3x8PSK, après deux décalages temporels d'un temps symbole des trains I et Q, on devrait avoir obtenu la synchronisation de branches. Si ce n'est pas le cas, il s'agit de fausses alarmes dues aux conditions de transmission. A ce titre, le circuit 50 compte le nombre de décalages temporels opérés, par exemple pendant une durée 3T et, si 3 décalages successifs sont opérés, il augmente la durée de comptage T et/ou la valeur du seuil S. Les nouvelles valeurs de T et de S sont respectivement fournies à un compteur 51 et à un comparateur 52.

Selon un autre mode de réalisation, représenté à la figure 6, la durée de comptage T par le compteur 18 est prédéterminée et à priori quelconque (tout en étant courte pour limiter le temps d'acquisition de synchronisation de branches), et les moyens de décision de synchronisation de branches comprennent un dispositif de commande 60 qui décale les trains de symbole I et Q pour que les trains de symbole appliqués au décodeur de Viterbi 15 soient ceux pour lesquels le nombre de changements de niveaux observé est le plus faible. Le principe retenu est ici que le décalage pour lequel le nombre de changements d'états du signal SCD est le plus faible correspond à celui pour lequel il y a effectivement synchronisation de branches. Lorsque la synchronisation de branches est obtenue, le nombre de changements d'états du signal SCD pendant une durée T est très inférieur à celui obtenu lorsqu'il n'y a pas de synchronisation de branches. En l'absence de synchronisation de branches, le signal SCD présente en fait environ autant de niveaux "1" que de niveaux "0", alors que le nombre de niveaux "0" (pour l'exemple des figures 3 et 4) est beaucoup plus important lorsque la synchronisation de branches est obtenue.

Le dispositif de commande peut fonctionner séquentiellement : en l'absence de synchronisation de branches, le nombre de changements d'états du signal SCD pendant la durée T est mémorisé pour chaque hypothèse de décalage. Des décalages successifs des trains I et Q sont alors réalisés jusqu'à avoir balayé toutes les hypothèses. L'hypothèse pour laquelle le nombre de changements d'états est le plus faible est alors reconnue comme celle constituant la bonne synchronisation de branches et les trains I et Q sont décalés en conséquence.

L'invention concerne également un récepteur de données numériques codées en treillis multidimensionnel comprenant un dispositif de synchronisation de branches tel que décrit précédemment.

L'invention permet d'obtenir un gain de temps de 5 environ par rapport à la solution connue et présente l'avantage de considérer les séquences codées issues du décodeur de Viterbi pour décider si oui ou non la synchronisation de branches est acquise. Ces séquences codées auront donc déjà subi un filtrage par le critère de maximum de vraisemblance.

**Revendications**

1. Dispositif de synchronisation de branches pour récepteur de données numériques codées en treillis multidimensionnel à l'aide d'un codeur convolutif, ledit dispositif comprenant un décodeur de Viterbi (15) recevant deux trains de symboles (I, Q) issus d'un signal reçu (10) et fournissant des séquences codées ($Z_0$, $Z_1$, $Z_2$), ainsi que des moyens (11, 12) de décalage temporel desdits trains de symbole (I, Q), lesdits moyens (11, 12) de décalage temporel étant pilotés par des moyens (18, 19, 50, 51, 52, 60) de décision de synchronisation de branches engendrant un signal (SCT) de commande de décalage temporel, caractérisé en ce que lesdits moyens (18, 19, 50, 51, 52, 60) de décision de synchronisation de branches coopèrent avec un circuit de calcul (20) recevant lesdites séquences codées ($Z_0$, $Z_1$, $Z_2$) et fournissant auxdits moyens (18, 19, 50, 51, 52, 60) de décision de synchronisation un signal de sortie (SCD) d'un premier type lorsque lesdites séquences codées ($Z_0$, $Z_1$, $Z_2$) correspondent à des séquences qui seraient directement issues dudit codeur convolutif, ou fournissant un signal de sortie (SCD) d'un deuxième type lorsque lesdites séquences codées ($Z_0$, $Z_1$, $Z_2$) ne correspondent pas à des séquences qui seraient issues dudit codeur convolutif, ledit signal de sortie (SCD) étant appliqué auxdits moyens (18, 19, 50, 51, 52, 60) de décision de synchronisation de branches, en vue de déterminer ledit signal (SCT) de commande de décalage.

2. Dispositif selon la revendication 1, caractérisé en ce que lesdits signaux de sortie (SCD) dudit premier et dudit deuxième type sont constitués par des signaux numériques.

3. Dispositif selon la revendication 1, caractérisé en ce que ledit signal de sortie (SCD) dudit premier type est un niveau logique constant en l'absence de perturbations.

4. Dispositif selon l'une des revendications 1 à 3, caractérisé en ce que lesdits moyens (18, 19, 50, 51, 52, 60) de décision de synchronisation de branches comprennent un dispositif à seuil (18, 19, 51, 52) générant un signal (SCT) de commande de décalage temporel lorsque le nombre de changements de niveaux dudit signal de sortie (SCD), observé pendant une durée donnée (T), atteint une valeur de seuil (S).

5. Dispositif selon la revendication 4, caractérisé en ce que ladite durée donnée (T) et ladite valeur de seuil (S) sont prédéterminées.

6. Dispositif selon la revendication 4, caractérisé en ce que lesdits moyens de décision de synchronisation de branches (50, 51, 52) comprennent également un circuit (50) de décision de fausse alarme auquel est appliqué ledit signal (SCT) de commande de décalage temporel, ledit circuit (50) de détection de fausse alarme corrigeant la valeur de ladite durée d'observation (T) et/ou de ladite valeur de seuil (S) lorsque toutes les hypothèses de décalage temporel ont été testées sans obtenir ladite synchronisation de branches.

7. Dispositif selon l'une des revendications 1 à 3, caractérisé en ce que lesdits moyens (18, 60) de décision de synchronisation de branches comprennent un compteur (18) des changements de niveau dudit signal de sortie (SCD) pendant une durée prédéterminée (T), ledit compteur (18) fournissant, pour chaque hypothèse de décalage temporel, le nombre de changements de niveaux observé à un dispositif de commande (60) qui décale lesdits trains de symbole (I, Q) pour que lesdits trains de symbole (I, Q) appliqués audit décodeur de Viterbi (15) soient ceux pour lesquels ledit nombre de changements de niveaux observé est le plus faible.

8. Dispositif selon l'une des revendications 1 à 7, caractérisé en ce que ledit codeur convolutif étant linéaire, ledit circuit de calcul (20) est constitué par un calculateur de syndrome.

9. Dispositif selon l'une des revendications 1 à 7, caractérisé en ce que ledit codeur convolutif étant non linéaire, ledit circuit de calcul (20) est un agencement de logique combinatoire dérivé de la construction dudit codeur convolutif non linéaire.

10. Récepteur de données numériques codées en treillis multidimensionnel comprenant un dispositif de synchronisation de branches selon l'une des revendications 1 à 9.

# FIG.1

# FIG.2

# FIG.3

# FIG.4

# FIG.5

# FIG.6

# EP 0 704 981 A1

Office européen
des brevets

**RAPPORT DE RECHERCHE EUROPEENNE**

Numero de la demande

EP 95 40 2140

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP-A-0 233 788 (SONY CORPORATION)<br>* abrégé *<br>* page 3, alinéa 4 *<br>* page 11, alinéa 5 - page 16, ligne 2; revendications; figures *<br>--- | 1-8,10 | H03M13/12<br>H04L7/04 |
| D,A | IEEE INTERNATIONAL CONFERENCE ON COMMUNICATIONS ICC 1988, PHILADELPHIA, US, 12.-15.06.1988,<br>vol.1, 12 Juin 1988, IEEE, NEW YORK, US<br>pages 80 - 84<br>M. D. RAUCHWERK: 'A Technique for Multidimensional Symbol and Multiplexing Frame Synchronization in Multidimensional Trellis Coded Modems using Non-Standard Baud.'<br>* abrégé *<br>* page 80, colonne de gauche, alinéa 2 *<br>* page 80, colonne de droite, alinéa 5 - page 81, colonne de droite, alinéa 4 *<br>--- | 1-8,10 | |
| A | IEEE GLOBAL TELECOMMUNICATIONS CONFERENCE & EXHIBITION, SAN DIEGO, US, 02.-05.12.1990,<br>vol.1, 2 Décembre 1990, IEEE, NEW YORK, US<br>pages 604 - 608, XP218798<br>M. MOENECLAEY / PH. SANDERS:<br>'Syndrome-based Viterbi Decoder Node Synchronization and Out-of-Lock Detection.'<br>* le document en entier *<br>---<br><br>-/-- | 1-8,10 | **DOMAINES TECHNIQUES RECHERCHES (Int.Cl.6)**<br><br>H03M<br>H04L |

Le présent rapport a été établi pour toutes les revendications

| Lieu de la recherche | Date d'achèvement de la recherche | Examinateur |
|---|---|---|
| LA HAYE | 24 Janvier 1996 | Gries, T |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
                                                
& : membre de la même famille, document correspondant

EPO FORM 1503 03.82 (P04C02)

Office européen
des brevets

**RAPPORT DE RECHERCHE EUROPEENNE**

Numero de la demande

EP 95 40 2140

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | ELECTRONICS LETTERS., vol.30, no.13, 23 Juin 1994, LONDON GB pages 1036 - 1037, XP461212 C. BERROU / C. DOUILLARD: 'Pseudo-syndrome method for supervising Viterbi decoders at any coding rate.' * le document en entier * | 1-8,10 | |
| A | EP-A-0 208 537 (CODEX CORPORATION) * abrégé * * page 2, ligne 1 - page 4, ligne 17 * | 1-8,10 | |
| A | EP-A-0 425 153 (HUGHES AIRCRAFT COMPANY) * abrégé * * colonne 1, ligne 31 - colonne 5, ligne 4 * | 1-8,10 | |
| A | IEEE TRANSACTIONS ON COMMUNICATIONS, vol.COM-32, no.5, Mai 1984, NEW YORK US pages 524 - 531 G. LORDEN / R. J. MCELIECE / L. SWANSON: 'Node Synchronization for the Viterbi Decoder.' * page 524, colonne de droite, alinéa 1 - page 526, colonne de droite, alinéa 4 * | 1-8,10 | |
| P,X | US-A-5 428 646 (EYUBOGLU) * colonne 2, ligne 21 - ligne 30 * * colonne 9, ligne 21 - ligne 30 * * revendications; figures 3,4,6 * | 1-10 | |

DOMAINES TECHNIQUES RECHERCHES (Int.Cl.6)

Le présent rapport a été établi pour toutes les revendications

| Lieu de la recherche | Date d'achèvement de la recherche | Examinateur |
|---|---|---|
| LA HAYE | 24 Janvier 1996 | Gries, T |